# EUROPÄISCHE PATENTSCHRIFT

(11) **EP 2 227 071 B1**
(45) Veröffentlichungstag und Bekanntmachung des Hinweises auf die Patenterteilung: **19.08.2015**
(21) Anmeldenummer: 10155107.5
(22) Anmeldetag: 02.03.2010
(51) Int. Cl.: H05K 3/20, H05B 41/00, H05K 1/11, H05K 3/40, H05B 41/02

(54) **Zündgerät für eine Hochdruckgasentladungslampe**
Ignition device for a high pressure gas discharge lamp
Boîte d'allumage pour une lampe à décharge haute pression

(30) Priorität: 06.03.2009 DE 102009012088
(43) Veröffentlichungstag der Anmeldung: 08.09.2010
(73) Patentinhaber: Hella KGaA Hueck & Co., 59552 Lippstadt (DE)
(72) Erfinder: Bewermeyer, Frank, 33161 Hövelhof (DE); Daub, Wolfgang, 59609 Anröchte (DE); Eusterbrock, Michael, 33397 Rietberg (DE); Puke, Volker, 48324 Sendenhorst (DE); Kanne, Gideon, 59590 Geseke (DE)

(56) Entgegenhaltungen:
- WO-A1-02/27746
- US-A1- 2004 001 319

## Beschreibung

Die Erfindung betrifft ein Zündgerät für eine Hochdruckgasentladungslampe gemäß dem Oberbegriff des Anspruchs 1.

In Kraftfahrzeugen werden für Frontscheinwerfer wegen der besseren Lichtausbeute vermehrt Hochdruckgasentladungslampen wie z.B. Xenonlampen eingesetzt. Diese Lampen benötigen zum Starten eine hohe Zündspannung von mehreren kV, die als Spannungsimpuls in einem Zündgerät erzeugt wird. Diese Zündgeräte umfassen ein Gehäuse, in dem ein Zündtransformator und eine Leiterplatte mit elektrischen/ elektronischen Bauteilen und Schaltungen befestigt sind. Dem Zündgerät ist gewöhnlich ein Vorschaltgerät vorgeschaltet.

Solche Zündgeräte einschließlich der Leiterplatten sind an sich bekannt. Die Leiterplatten sind mit den Bauteilen bestückt, die auf Kontaktflächen verlötet sind. Bei den bekannten Leiterplatten muss vor dem Verlöten an vorbestimmten Stellen Lötstopplack aufgetragen werden, damit hier kein Kontakt hergestellt wird. Das Auftragen des Lötstopplacks ist mit entsprechendem Aufwand verbunden.

Die WO 02/27746 A1 offenbart einen Lampensockel mit einem Zündtransformator, bei dem als Montageplatte ein Stanzgitter einseitig mit einem formstabilen Kunststoff beschichtet ist. Die Montageplatte ist entsprechend einem Gehäuse abgewinkelt.

Aus der US 2004/001319 A1 ist eine Busanordnung aus Blechen bekannt, die auf der Oberfläche einer Leiterplatte befestigt sind.

Die DE 103 39 587 A1 beschreibt einen Lampensockel mit einem Zündtransformator für eine Hochdruckgasentladungslampe. Der Zündtransformator umfasst ein Gehäuse, das mindestens eine Wicklung umschließt. Zum lagerichtigen Einbau des Transformators in den Lampensockel ist der Zündtransformator an seiner Außenseite mit Stegen versehen. Der Lampensockel weist entsprechende Nuten sowie Anstandhalter auf. Der Zündtransformator soll auf diese Weise für einen automatischen Einbau in den Lampensockel und für eine automatisierte Kontaktierung geeignet sein. Eine Ausbildung einer Leiterplatte (Montageplatine) ist nicht näher beschrieben.

Aus der DE 10 2004 044 368 A1 ist eine Zündvorrichtung mit einem Zündtransformator für eine Hochdruckgasentladungslampe bekannt, bei dem eine Sekundärwicklung geordnet, dass ein Hochspannung führendes Ende der Sekundärwicklung innen liegend angeordnet ist. Auf diese Weise soll der Zündtransformator verbessert werden. Eine automatisierte Fertigung ist schwierig und aufwändig. Der Zündtransformator ist mit einer Leiterplatte (Montageplatine) verbunden, die nicht näher erläutert ist.

In der DE 20 2005 007 484 U1 ist ein Zündtransformator für eine Gasentladungsleuchte mit einem offenen, nicht geradlinigen magnetischen Kern und einem Spulenkörper offenbart, der auf dem Kern aufgebracht ist und mehrere Kammern zur Aufnahme einer Sekundärwicklung aufweist. Auf diese Weise soll bei kompakter Bauweise die Flexibilität bei der Auslegung des Zündtransformators erzielt werden. Der Zündtransformator ist aufwändig und nur schwer automatisch zu fertigen. Eine Leiterplatte (Träger) ist nur kurz erwähnt.

Aufgabe der Erfindung ist es, ein Zündgerät für eine Hochdruckgasentladungslampe zu schaffen, bei dem eine Leiterplatte einfach und mit geringem Aufwand mit elektrischen und/oder elektronischen SMD (Surface Mounted Devices) bestückt werden kann.

Die Aufgabe ist durch die Merkmale des Anspruchs 1 gelöst. Das Stanzgitter ist mit nicht leitendem Kunststoff teilweise umspritzt, wobei eine Größe von zweiten Kontaktflächen auf die anzubindenden Bauteile und auf elektrische Anschlüsse des Zündtransformators abgestimmt ist. Dies bewirkt, dass eine mechanische und elektrische Verbindung der Bauteile mit der Leiterplatte stark vereinfacht wird. Es muss kein Lötstopplack aufgetragen werden, weil der Kunststoff den Kontakt an den Stellen verhindert, an denen kein Kontakt vorhanden sein soll. Hierdurch werden ein Arbeitsschritt und Betriebsmittel eingespart. Die automatisierte Fertigung des Zündgeräts wird insgesamt erleichtert.

Die Unteransprüche betreffen die vorteilhafte Ausgestaltung der Erfindung.

In einer Ausbildung der Erfindung ist eine Größe der zweiten Kontaktflächen auf die anzubindenden SMD abgestimmt. Hierdurch werden Kurzschlüsse noch besser vermieden.

In eine weiteren Ausbildung weisen die den Anschlüssen des Zündtransformators zugeordneten Kontaktflächen jeweils mindestens eine Durchgangsbohrung auf. Hierdurch können bei weitgehend zusammengefügtem Zündgerät Anschlüsse des Zündtransformators mittels Laserschweißen mit den zugeordneten Kontaktflächen verbunden werden.

In einer Alternative zu den Kontaktflächen sind den Anschlüssen des Zündtransformators Federlaschen zugeordnet. Hierfür weist die Leiterplatte im Bereich des Zündtransformators Aussparungen auf, in die die Federlaschen ragen.

Anhand der schematischen Zeichnung wird die Erfindung nachfolgend näher erläutert. Dabei zeigt:
- Figur 1: eine Explosionszeichnung eines Zündgeräts,
- Figur 2: einen stark vereinfachten Längsschnitt durch eine unbestückte Leiterplatte
- Figur 3: eine perspektivische Ansicht auf eine bestückte Seite der Leiterplatte und
- Figur 4: eine perspektivische Ansicht auf eine andere Leiterplatte.

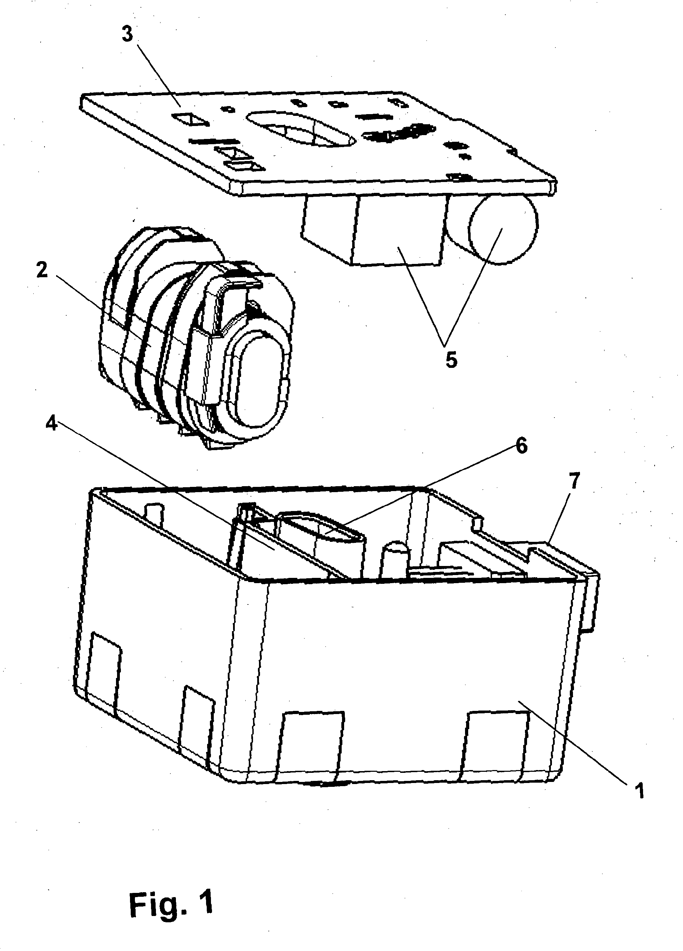

Wie aus der Figur 1 ersichtlich umfasst ein Zündgerät für eine Hochdruckgasentladungslampe ein quaderförmiges Gehäuse 1, einen Zündtransformator 2 und eine Leiterplatte 3. Das Gehäuse 1 ist aus einem elektrisch nicht leitendem Material wie z.B. Kunststoff gefertigt, mittels einer Wand 4 quergeteilt und mittels eines nicht dargestellten Deckels verschlossen. In einem hier linken Teil des Gehäuses 1 ist der Zündtransformator 2 gelagert. In den anderen Teil ragen elektrische und/oder elektronische Bauteile 5, die auf der Leiterplatte 3 befestigt sind. Weiterhin ist in dem anderen Teil ein Lampensockel 6 angeordnet. Die Leiterplatte 3 ist parallel zu den Hauptflächen des Gehäuses 1 in diesem gelagert. Für einen elektrischen Anschluss des Zündgeräts ist an dem Gehäuse 1 ein Stecker 7 angeordnet, der mit der Leiterplatte 3 kontaktiert ist.

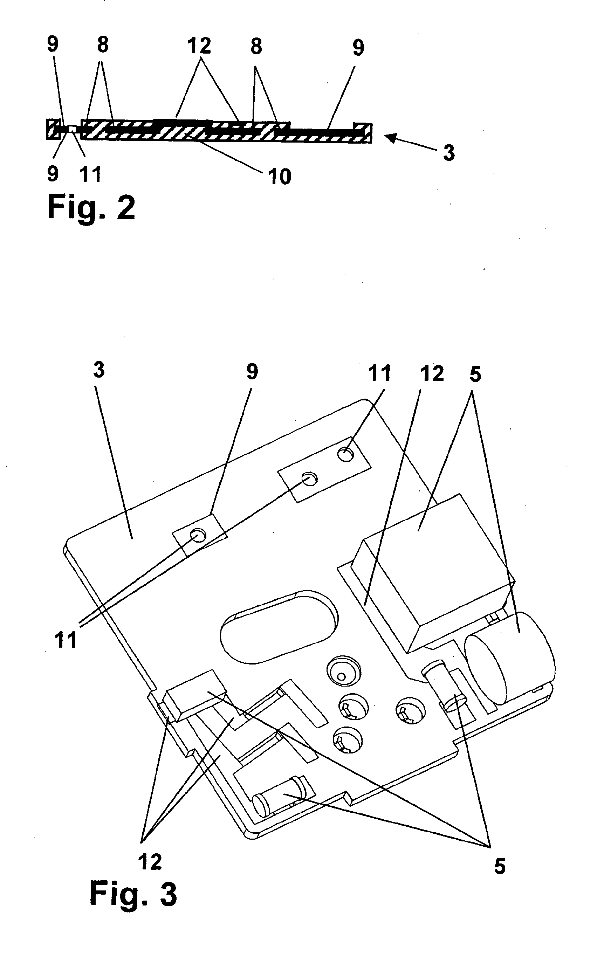

Die im Wesentlichen rechteckige Leiterplatte 3, die in den Figuren 2 und 3 genauer dargestellt ist, umfasst ein Stanzblech 8, das Leiterbahnen und Kontaktflächen 9, 12 bildet. In dem Stanzblech 8 sind an Stellen, an denen eine elektrische Verbindung unterbrochen sein soll, Öffnungen angeordnet. Das Stanzblech 8 ist mit Ausnahme der Kontaktflächen 9, 12 mit einer Schicht 10 aus elektrisch nicht leitendem Kunststoff ummantelt, wobei die Öffnungen mit dem Kunststoff verfüllt sind. Die Kontaktflächen 9, 12 sind hier in unterschiedlichen Ebenen angeordnet. Erste Kontaktflächen 9 befinden sich unterhalb einer Oberfläche der Schicht 10. Zweite Kontaktflächen 12 sind z.B. in einer Ebene mit der Oberfläche der Schicht 10 oder ragen entsprechend weit aus dieser heraus.

Auf zweiten Kontaktflächen 12 sind die Bauteile 5 befestigt. Die Bauteile 5 sind z.B. flächig montiert (Surface Mounted Device SMD) oder bedrahtet. Die zweiten Kontaktflächen 12 sind entsprechend ausgebildet, wobei ihre Größen auf die zugehörigen Bauteile 5 und Anschlüsse des Zündtransformators 2 so abgestimmt sind, dass eine nicht gewollte Kontaktierung durch Lot zwischen den Kontaktflächen 9, 12 auf jeden Fall vermieden ist. Das bedeutet, dass die Größe der zweiten Kontaktflächen 12 der entsprechenden Fläche der zugeordneten Bauteile 5 zuzüglich eines geringen Spiels entspricht. Die den Anschlüssen des Zündtransformators 2 zugeordneten Kontaktflächen weisen eine oder zwei Durchgangsbohrungen 11 auf.

Für die Herstellung der Leiterplatte 3 wird aus einem Blech das Stanzgitter 8 ausgestanzt, wobei die Leiterbahnen, die Kontaktflächen 9, 12 und die Durchgangsbohrungen 11 gebildet werden. Die unterschiedlichen Ebenen der Kontaktflächen 9, 12 werden hierbei durch Tiefziehen oder Prägen geformt. Das fertige Stanzgitter 8 wird mit Ausnahme der Kontaktflächen 9, 12 mit der Schicht 10 aus Kunststoff umspritzt.

Die Leiterplatte 3 wird anschließend mit den Bauteilen 5 durch Verlöten bestückt. Hierbei verhindert die Schicht 10 ungewollte Kontaktierungen (Brücken), weil das Lot hier nicht haftet.

Zur vollautomatischen Montage des Zündgeräts wird der Zündtransformator 2 in das Gehäuse 1 eingesetzt und ein vorbestimmter Anschluss des Zündtransformators 2 an einem entsprechenden Kontakt des Lampensockels 6 mittels Laserschweißen befestigt. Der Zündtransformator 2 wird mit Vergussmasse verfüllt. Die Leiterplatte 3 wird auf das Gehäuse 1 aufgesetzt und befestigt. Hierbei liegen die ersten Kontaktflächen 9 der Leiterplatte 3 an Endbereichen einer Primärwicklung sowie an einem Kontaktblech des Zündtransformators 2 an. Die Endbereiche und das Kontaktblech bilden weitere elektrische Anschlüsse des Zündtransformators 2. Die ersten Kontaktflächen 9 einerseits sowie die Endbereiche der Primärwicklung und das Kontaktblech andererseits werden mittels Laserschweißen miteinander verbunden. Schließlich wird das Gehäuse 1 mit dem Deckel verschlossen.

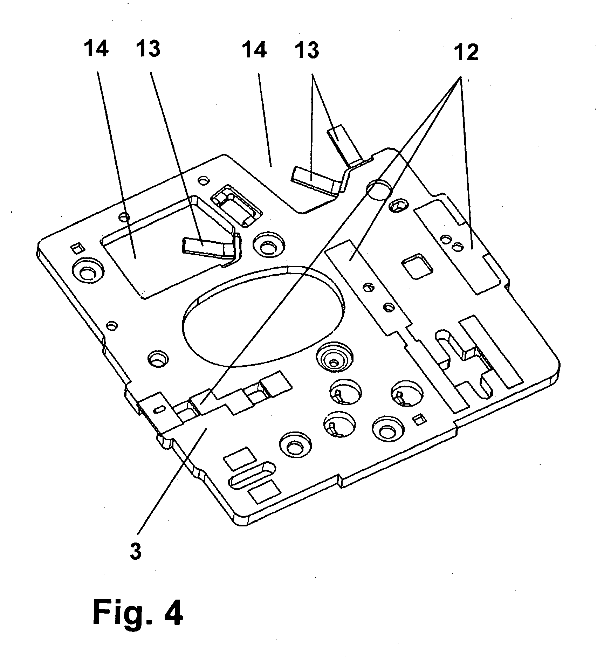

Eine alternative Ausgestaltung der Leiterplatte 3 ist in der Figur 4 dargestellt. Diese Leiterplatte 3 unterscheidet sich von der oben beschriebenen durch Folgendes: die Leiterplatte 3 ist ohne die Bauteile 5 dargestellt. Im Bereich der Anschlüsse des Zündtransformators 2 weist die Leiterplatte 3 zwei Aussparungen 14 auf, in die insgesamt drei Federlaschen 13 ragen. In eine erste, im Wesentlichen rechteckige der Aussparungen 14 weist eine der Federlaschen 13 zum Anschluss eines der Endbereiche der Primärwicklung. In eine zweite der Aussparungen 14, bei der ein Eckbereich der Leiterplatte 3 ausgespart ist, weisen die beiden übrigen der Federlaschen 13 zum Anschluss des anderen Endbereichs und des Kontaktblechs.

Bei der Montage liegen die Federlaschen 13 an den an den Endbereichen der Primärwicklung sowie an dem Kontaktblech an. Die Federlaschen 13 einerseits sowie die Endbereiche der Primärwicklung und das Kontaktblech andererseits werden mittels Laserschweißen miteinander verbunden.

### Bezugszeichenliste

- 1: Gehäuse
- 2: Zündtransformator
- 3: Leiterplatte
- 4: Wand
- 5: Bauteil
- 6: Lampensockel
- 7: Stecker
- 8: Stanzgitter
- 9, 12: Kontaktfläche
- 10: Schicht
- 11: Durchgangsbohrung
- 13: Federlasche
- 14: Aussparung

## Patentansprüche

1. Zündgerät für eine Hochdruckgasentladungslampe, umfassend ein Gehäuse (1),
einen Zündtransformator (2) und
eine Leiterplatte (3) mit elektrischen und/oder elektronischen Bauteilen und Schaltungen, wobei die Leiterplatte (3) mindestens ein Stanzgitter (8) enthält, auf dessen Oberfläche erste und zweite Kontaktflächen (9, 12) ausgebildet sind,
**dadurch gekennzeichnet, dass** die ersten und zweiten Kontaktflächen (9, 12) in unterschiedlichen Ebenen ausgebildet sind und dass das Stanzgitter (8) mit Ausnahme der Kontaktflächen (9, 12) mit einer Schicht (10) aus nicht leitendem Kunststoff ummantelt ist, wobei die zweiten Kontaktflächen (12), die für SMD (5) bestimmt sind, in dem Stanzgitter (8) derart angeordnet sind, dass sie in einer Ebene mit der Schicht (10) liegen.

2. Zündgerät nach Anspruch 1, **dadurch gekennzeichnet, dass** eine Größe der zweiten Kontaktflächen (12) auf die anzubindenden SMD (5) abgestimmt ist.

3. Zündgerät nach Anspruch 1 oder 2, **dadurch gekennzeichnet, dass** die den Anschlüssen des Zündtransformators (2) zugeordneten ersten Kontaktflächen (9) jeweils mindestens eine Durchgangsbohrung (11) aufweisen.

4. Zündgerät nach Anspruch 1 oder 2, **dadurch gekennzeichnet, dass** die den Anschlüssen des Zündtransformators (2) zugeordneten ersten Kontaktflächen (9) als Federlaschen ausgelegt sind.

## Claims

1. Igniter for a high pressure discharge lamp, comprising a housing (1),
an ignition transformer (2) and
a PCB (3) with electrical and / or electronic components and circuits, wherein the PCB (3) has at least one lead frame (8), with first and second contact faces (9,12) embodied on its suface,
**characterized in that** the first and second contact faces (9,12) are embodied in different levels and that the lead frame (8) with the exception of the contact faces (9,12) is coated with a coat (10) of nonconductive plastic material, wherein the second contact faces (12) which are intended for SMD (5), are arranged in the lead frame (8) in such a manner that they are on one level with the coat (10).

2. Igniter according to Claim 1, **characterized in that** a size of the second contact faces (12) is matched with the SMD (5) to be connected.

3. Igniter according to Claim 1 or 2, **characterized in that** the first contact faces (9) assigned to the terminals of the ignition transformer (2) each have at least one through bore (11).

4. Igniter according to Claim 1 or 2, **characterized in that** the first contact faces (9) assigned to the terminals of the ignition transformer (2) are designed as spring tabs.

## Revendications

1. Dispositif d'allumage pour une lampe à décharge à haute pression, comprenant un boîtier (1),
un transformateur d'allumage (2) et
un circuit imprimé (3) avec des composants électriques et/ou électroniques et des circuits, le circuit imprimé (3) contenant au moins une grille estampée (8) sur la surface de laquelle des premières et des deuxièmes surfaces de contact (9, 12) sont formées,
**caractérisé en ce que**
les premières et les deuxièmes surfaces de contact (9, 12) sont formées dans des plans différents et que la grille estampée (8), à l'exception des surfaces de contact (9, 12), est enrobée d'une couche (10) de matière plastique non conductrice, les deuxièmes surfaces de contact (12) qui sont destinés aux composants montés en surface (SMD) (5) étant disposées de telle manière sur la grille estampée (8) qu'elles se trouvent dans le même plan que la couche (10).

2. Dispositif d'allumage selon la revendication 1, **caractérisé en ce qu'**une dimension des deuxièmes surfaces de contact (12) est adaptée aux composants SMD (5) à connecter.

3. Dispositif d'allumage selon la revendication 1 ou 2, **caractérisé en ce que** les premières surfaces de contact (9) attribuées aux raccords du transformateur d'allumage (2) présentent chaque fois au moins un trou débouchant (11).

4. Dispositif d'allumage selon la revendication 1 ou 2, **caractérisé en ce que** les premières surfaces de contact (9) attribuées aux raccords du transformateur d'allumage (2) sont effectuées en tant que jumelles de ressort.
